(19)

**Europäisches Patentamt**
**European Patent Office**
**Office européen des brevets**

(11) **EP 2 894 672 A1**

(12) **EUROPEAN PATENT APPLICATION**

(43) Date of publication:
**15.07.2015 Bulletin 2015/29**

(51) Int Cl.:
*H01L 27/32* (2006.01)    *G06F 3/041* (2006.01)
*G09F 9/30* (2006.01)

(21) Application number: **15150261.4**

(22) Date of filing: **07.01.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **13.01.2014   KR 20140004088**

(71) Applicant: **Samsung Display Co., Ltd.**
**Gyeonggi-Do (KR)**

(72) Inventors:
- **Kim, Hoonsik**
  **605-704 Seongnam-si, Gyeonggi-do (KR)**
- **Seo, Dongwoo**
  **101-1304 Seoul (KR)**

- **Kee, In Seo**
  **202-803 Seongnam-si, Gyeonggi-do (KR)**
- **Jung, Taehyeog**
  **628-1902 Hwaseong-si, Gyeonggi-do (KR)**

(74) Representative: **Dr. Weitzel & Partner**
**Patent- und Rechtsanwälte mbB**
**Friedenstrasse 10**
**89522 Heidenheim (DE)**

Remarks:
A request for correction of the description has been filed pursuant to Rule 139 EPC. A decision on the request will be taken during the proceedings before the Examining Division (Guidelines for Examination in the EPO, A-V, 3.).

(54) **Flexible display device**

(57)    A flexible display device includes a flexible display panel, a flexible outer member disposed on the flexible display panel, and a stress control member disposed between the flexible display panel and the flexible outer member, wherein the stress control member is configured to define neutral planes in the flexible display panel and the flexible outer member when the flexible display device is bent.

FIG. 9A

EP 2 894 672 A1

**Description**

BACKGROUND

FIELD

The present disclosure relates to a flexible display device, as per the preamble of claim 1. DISCUSSION OF THE BACKGROUND

Recently, bendable or foldable display devices (hereinafter, referred to as flexible display devices) have been developed. The flexible display device includes a flexible display panel and various outer members.

The outer members may have different functions from each other. The outer members are disposed on either surface of the flexible display panel and may be bent together with the flexible display panel.

It is the objective of the invention to provide a flexible display device as per the preamble of claim 1 capable of reducing damage from bending. The said objective mill be achieved by the characterizing portion of claim 1 The above information disclosed in this Background section is only for enhancement of understanding of the background of the invention and therefore it may contain information that does not form any part of the prior art nor what the prior art may suggest to a person of ordinary skill in the art.

SUMMARY

Exemplary embodiments of the present disclosure provide a flexible display device including members of which stresses may be partially decoupled from each other when bent.

Additional features of the invention will be set forth in the description which follows, and in part will be apparent from the description, or may be learned by practice of the invention.

An exemplary embodiment of the present invention discloses a flexible display panel, including a flexible display panel, a flexible outer member disposed on the flexible display panel, and a stress control member disposed between the flexible display panel and the flexible outer member, wherein the stress control member is configured to define neutral planes in the flexible display panel and the flexible outer member when the flexible display device is bent.

An exemplary embodiment of the present invention discloses a flexible display device, including a flexible display panel, a flexible outer member disposed on the flexible display panel, and a stress control member disposed between the flexible display panel and the flexible outer member and configured to physically couple the flexible display panel and the flexible outer member to each other, wherein the flexible display device is configured to partially decouple a stress of the flexible display panel from a stress of the flexible outer member by the stress control member when the flexible display device is bent, such that a strain at one surface of the flexible display panel adjacent to the stress control member occurs by either one of a compressive stress or a tensile stress, and a strain at one surface of the flexible outer member adjacent to the stress control member occurs by the other one of the compressive stress or the tensile stress.

An exemplary embodiment of the present invention also discloses a flexible display device, including a flexible display panel member, flexible outer members disposed on the flexible display panel member, and stress control members, each disposed between the flexible display panel member and the flexible outer members, configured to physically couple the adjacent two members to each other, and have a maximum shear strain of a bent portion of about 150% or more when the flexible display device is bent.

BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the principles of the invention.

The inventive concepts will become more apparent in view of the attached drawings and accompanying detailed description.

FIG. 1A is a perspective view showing a flexible display device that is unfolded according to an exemplary embodiment of the inventive concepts;

FIG. 1B is a side view showing a flexible display device that is bent according to an exemplary embodiment of the inventive concepts;

FIG. 2 is a plan view showing a flexible display panel according to an exemplary embodiment of the inventive concepts;

FIG. 3 is an equivalent circuit diagram showing a pixel according to an exemplary embodiment of the inventive concepts;

FIG. 4 is a cross-sectional view showing a pixel according to an exemplary embodiment of the inventive concepts;

FIG. 5 is a cross-sectional view showing a touch panel according to an exemplary embodiment of the inventive concepts;

FIG. 6A is a side view showing a strain occurring in a member having a single layer when the single layered member is bent;

FIG. 6B is a side view showing a strain occurring in a member having a double layer when the double layered member is bent;

FIG. 7A is a side view showing a display device including members of which stresses are coupled to each other when the display apparatus is bent;

FIG. 7B is a graph showing a strain occurring in the display device shown in FIG. 7A;

FIG. 7C is a view showing a method of measuring a strain occurring in a display device;

FIG. 8A is a side view showing a display device including members of which stresses are decoupled from each other when the display device is bent;

FIG. 8B is a graph showing a strain occurring in the display device shown in FIG. 8A;

FIG. 9A is a cross-sectional view showing a display device according to an exemplary embodiment of the inventive concepts;

FIG. 9B is a graph showing a strain occurring in the display device shown in FIG. 9A;

FIG. 9C is a perspective view showing relation between a shear stress and a shear strain;

FIG. 9D is a view showing a method of measuring a shear strain of a stress control member of the display device of FIG. 9A;

FIG. 9E is a graph showing a radius of curvature according to a bending angle;

FIGS. 10A to 10C are graphs showing strains according to a modulus and a bending speed of a stress control member;

FIG. 11A is an image showing a cross-section of a bent experimental member;

FIG. 11B is a graph showing a strain occurring in the experimental member shown in FIG. 11A;

FIG. 12 is a side view showing a display device according to an exemplary embodiment of the inventive concepts;

FIG. 13 is a graph showing a strain occurring in the display device shown in FIG. 12;

FIGS. 14A to 14C are graphs showing shear strains of stress control members shown in FIG. 12; and

FIGS. 15A to 15E are side views showing display devices according to some exemplary embodiments of the inventive concepts.

## DETAILED DESCRIPTION OF THE EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items. It will be understood that for the purposes of this disclosure, "at least one of X, Y, and Z" can be construed as X only, Y only, Z only, or any combination of two or more items X, Y, and Z (e.g., XYZ, XYY, YZ, ZZ).

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms, "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, exemplary embodiments of the present invention will be explained in detail with reference to the accompanying drawings.

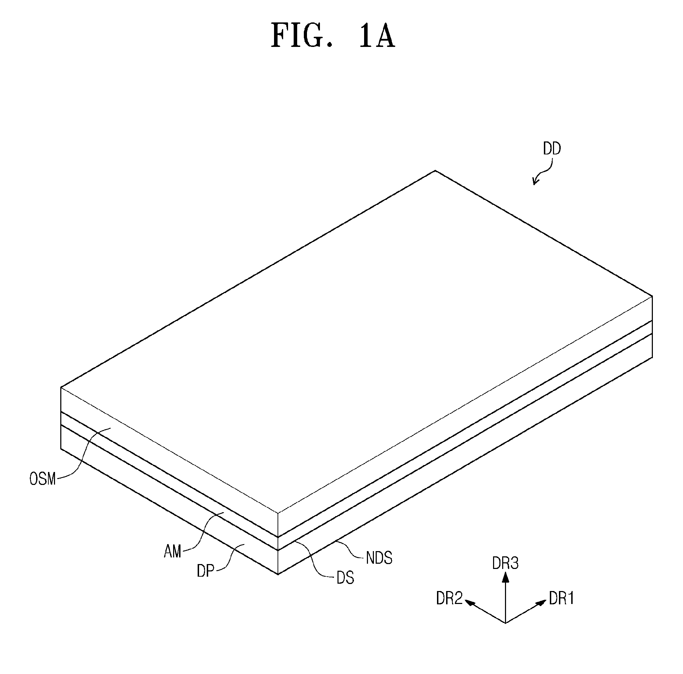

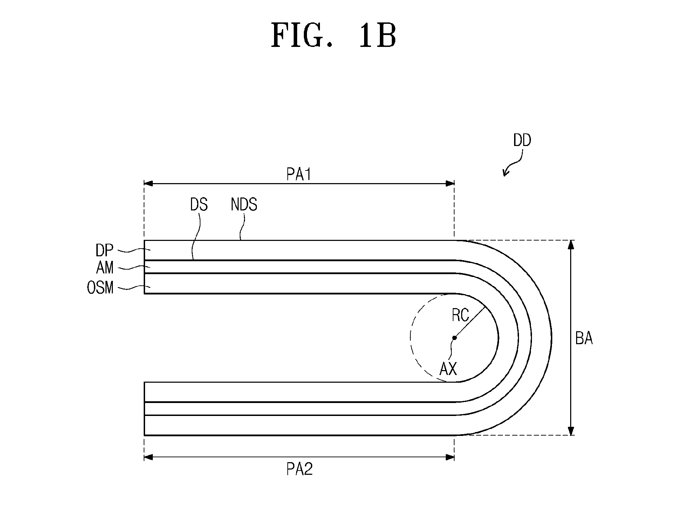

FIG. 1A is a perspective view showing a flexible display device that is unfolded according to an exemplary embodiment of the inventive concepts. FIG. 1B is a side view showing a flexible display device that is bent according to an exemplary embodiment of the inventive concepts.

As illustrated in FIG. 1A, a flexible display device DD (hereinafter, referred to as 'a display device') includes a flexible display panel DP (hereinafter, referred to as 'a display panel') and a flexible outer member OSM (hereinafter, referred to as 'an outer member') disposed on the display panel DP. The display device DD includes a stress control member AM disposed between the display panel DP and the outer member OSM.

The display panel DP includes a display surface DS defined by a first direction DR1 and a second direction DR2. The display panel DP displays an image to the user through the display surface DS. FIG. 1A illustrates the display panel DP having one display surface DS. In an exemplary embodiment, the display panel DP may display images through both surfaces thereof.

The stress control member AM is disposed on the display surface DS. The outer member OSM is disposed on the stress control member AM. The stress control member AM is disposed between the display panel DP and the outer member OSM. The display device DD may also include another outer member OSM disposed on a non-display surface NDS opposite to the display surface DS.

The outer member OSM may include at least one of a touch panel, an optical member, a window member, and a protecting member, stacked in a third direction DR3 perpendicular to the display surface DS.

As shown in FIG. 1B, the display device DD may be bent at a specific region. When the display device DD is bent, the display device DD may be divided into a bent region BA, a first planar region PA1, and a second planar region PA2.

Degrees of shape transformation of the first and second planar regions PA1 and PA2 are less than that of the bent region BA. The first and second planar regions PA1 and PA2 need not provide flat surfaces. In an exemplary embodiment, an entire portion of the display device DD may be curved or rolled, in other words, the bent region BA is not limited to the portion of the display device DD as illustrated in the drawings such that any portion of the display device DD may be at least one of the first and second planar regions PA1 and PA2 and the bent region BA.

The display device DD may have a radius of curvature RC. The radius of curvature RC is defined as the shortest distance from a bending axis AX to corresponding surface of the display device DD in the bent region BA. The radius of curvature RC may be in a range of about 3 mm to about 20 mm when the display device DD is bent at an angle of 180 degrees such that the first and second planar regions PA1 and PA2 are parallel to each other.

The display device DD may have various bending angle. FIG. 1B shows the bent display device DD having the first and second planar regions PA1 and PA2 parallel to each other as an example. The display device DD may have the bending angle of 120 degrees such that an internal angle between the first and second planar regions PA1 and PA2 may be 60 degrees. Also, the display device DD may have the bending angled of 90 degrees such that an internal angle between the first and second planar regions PA1 and PA2 may be 90 degrees. In FIG. 1B, the display device DD is bent with the outer member OSM disposed inside the bent display device DD. However, the inventive concepts are not limited thereto, and the display device DD may be bent with the display panel DP disposed inside the bent display device DD.

The display panel DP may be one of an organic light emitting display panel, an electrophoretic display panel, or an electrowetting display panel. The display panel DP includes a flexible base substrate, signal interconnections disposed on the base substrate, insulating layers disposed on the base substrate, and pixels electrically connected to the signal interconnections. Each of the pixels includes a display element and a circuit part controlling the display element.

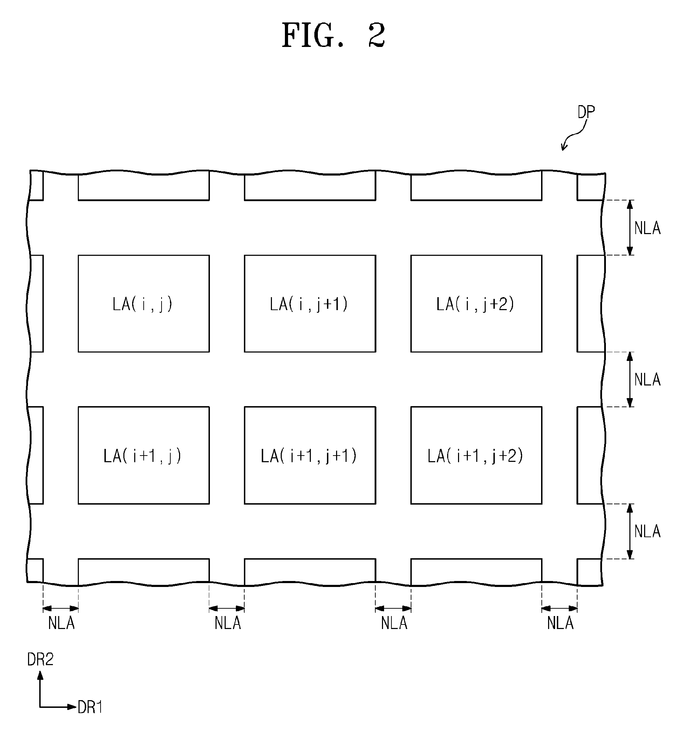

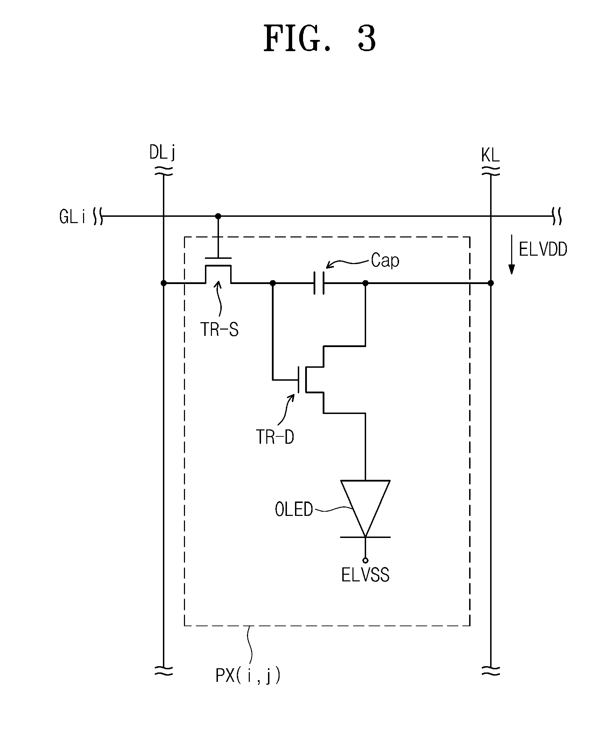

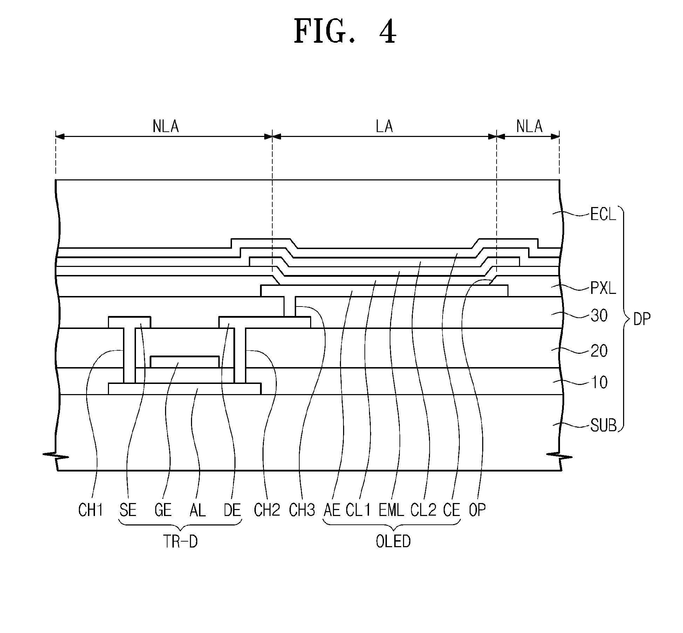

FIG. 2 is a plan view showing a flexible display panel DP according to an exemplary embodiment of the inventive concepts. FIG. 3 is an equivalent circuit diagram of a pixel according to an exemplary embodiment of the inventive concepts. FIG. 4 is a cross-sectional view showing a pixel according to an exemplary embodiment of the inventive concepts, corresponding to a portion of the equivalent circuit shown in FIG. 3. Hereinafter, an organic light emitting display panel according to an exemplary embodiment will be described with reference to FIGS. 2, 3, and 4.

As illustrated in FIG. 2, an organic light emitting display panel DP may be divided into a plurality of light emitting areas LA(i, j) to LA(i+1, j+2) and a non-light emitting area NLA surrounding the light emitting areas LA(i, j) to LA(i+1, j+2). FIG. 2 shows six light emitting areas LA(i, j) to LA(i+1, j+2) as an example.

FIG. 3 illustrates the equivalent circuit of a pixel PX(i, j). However, a structure of the pixel PX(i, j) is not limited thereto, and the structure of the pixel PX(i, j) may be variously modified. The pixel PX(i, j) receives a gate signal from an i-th gate line GLi and a data signal from a j-th data line DLj. The pixel PX(i, j) receives a first power voltage ELVDD from a power source line KL.

The pixel PX(i, j) includes an organic light emitting diode OLED as the display element. The pixel PX(i, j) may further include a switching thin film transistor TR-S, a driving thin film transistor TR-D, and a capacitor Cap as circuit parts.

The switching thin film transistor TR-S outputs the data signal applied to the j-th data line DLj in response to a gate signal applied to the i-th gate line GLi. The capacitor Cap stores electric charge and forms a charge voltage corresponding to the data signal received from the switching thin film transistor TR-S.

The driving thin film transistor TR-D is connected to the organic light emitting diode OLED. The driving thin film transistor TR-D controls a driving current flowing through the organic light emitting diode OLED in response to the electric charge stored in the capacitor Cap. The organic light emitting diode OLED emits light during the turn-on period of the driving thin film transistor TR-D.

Referring to FIGS. 2 and 3, the organic light emitting diode OLED is disposed to overlap with one light emitting area LA(i, j) among the light emitting areas LA(i, j) to LA(i+1, j+2) when viewed from a plan view. The switching thin film transistor TR-S, the driving thin film transistor TR-D, and the capacitor Cap are disposed to overlap with the non-light emitting area NLA adjacent to the one light emitting area LA(i, j) when viewed from a plan view. Additionally, the i-th gate line GLi and the j-th data line DLj are disposed to overlap with the non-light emitting area NLA adjacent to the one light emitting area LA(i, j) when viewed from a plan view.

Referring to FIG. 4, insulating layers 10, 20, and 30, the driving thin film transistor TR-D, and the organic light emitting diode OLED are disposed on a base substrate SUB.

The base substrate SUB may include a flexible plastic substrate. A semiconductor pattern AL of the driving thin film transistor TR-D is disposed on the base substrate SUB. A first insulating layer 10 is disposed on the base substrate SUB to cover the semiconductor pattern AL. The first insulating layer 10 may include at least one of an organic layer and an inorganic layer. The first insulating layer 10 may include a plurality of thin layers.

A control electrode GE of the driving thin film transistor TR-D is disposed on the first insulating layer 10. The second insulating layer 20 is disposed on the first insulating layer 10 to cover the control electrode GE. The second insulating layer 20 may include at least one of an organic layer and an inorganic layer. The second insulating layer 20 may include a plurality of thin layers.

An input electrode SE and an output electrode DE of the driving thin film transistor TR-D are disposed on the second insulating layer 20. The input electrode SE and the output electrode DE are connected to the semiconductor pattern AL respectively through a first contact hole CH1 and a second contact hole CH2, formed through the first and second insulating layers 10 and 20 exposing a portion of the semiconductor pattern AL. According to an exemplary embodiment, the driving thin film transistor TR-D may also have a bottom gate structure.

The third insulating layer 30 is disposed on the second insulating layer 20 to cover the input electrode SE and the output electrode DE. The third insulating layer 30 may include at least one of an organic layer and an inorganic layer. The third insulating layer 30 may include a plurality of thin layers.

A pixel defining layer PXL and the organic light emitting diode OLED are disposed on the third insulating layer 30. The organic light emitting diode OLED includes an anode AE, a first common layer CL1, an organic light emitting layer EML, a second common layer CL2, and a cathode CE, sequentially stacked. The anode AE is connected to the output electrode DE through a third contact hole CH3 formed through the third insulating layer 30exposing a portion of the output electrode DE. Positions of the anode AE and the cathode CE may be changed with each other according to the light emission direction of the organic light emitting diode OLED. Positions of the first and second common layers CL1 and CL2 may also be changed with respect to each other according to the light emission direction of the organic light emitting diode OLED.

The anode AE is disposed on the third insulating layer 30. An opening OP is formed through the pixel defining layer PXL to expose a portion of the anode AE. The first common layer CL1 is disposed on the anode AE. The common layer CL1 is disposed not only in the light emitting area LA but also in the non-light emitting area NLA. The first common layer CL1 includes a hole injection layer. The first common layer CL1 may further include a hole transport layer.

The organic light emitting layer EML is disposed on the first common layer CL1. The organic light emitting layer EML is disposed overlapping the opening OP. The second common layer CL2 is disposed on the first common layer CL1 and the light emitting layer EML. The second common layer CL2 includes an electron injection layer. The second common layer CL2 may further include an electron transport layer. The cathode CE is disposed on the second common layer CL2. The cathode CE is disposed not only in the light emitting area LA but also in the non-light emitting area NLA.

A sealing layer ECL is disposed on the cathode CE. The sealing layer ECL overlaps with the light emitting area LA and the non-light emitting area NLA. The sealing layer ECL may include at least one of an organic layer and an inorganic layer. According to an exemplary embodiment, the display panel DP may further include a fourth insulating layer disposed between the cathode CE and the sealing layer ECL to planarize the surface. Also, the sealing layer ECL may be replaced with a sealing substrate.

The switching thin film transistor TR-S may have the same structure as that of the driving thin film transistor TR-D. In addition, two electrodes of the capacitor Cap may be disposed on two of the first, second, and third insulating layers 10, 20, and 30.

Referring again to FIGS. 1A and 1B, the outer member OSM may be a touch panel. The touch panel senses an external input applied to the display device DD. When the user's finger or an electronic pen indicates a specific spot (hereinafter, referred to as 'an input spot'), the touch panel obtains coordinates information of the input spot. The touch panel may sense the external input in various ways, including an electrostatic capacitive mode, a resistive mode, an electromagnetic induction mode, etc.

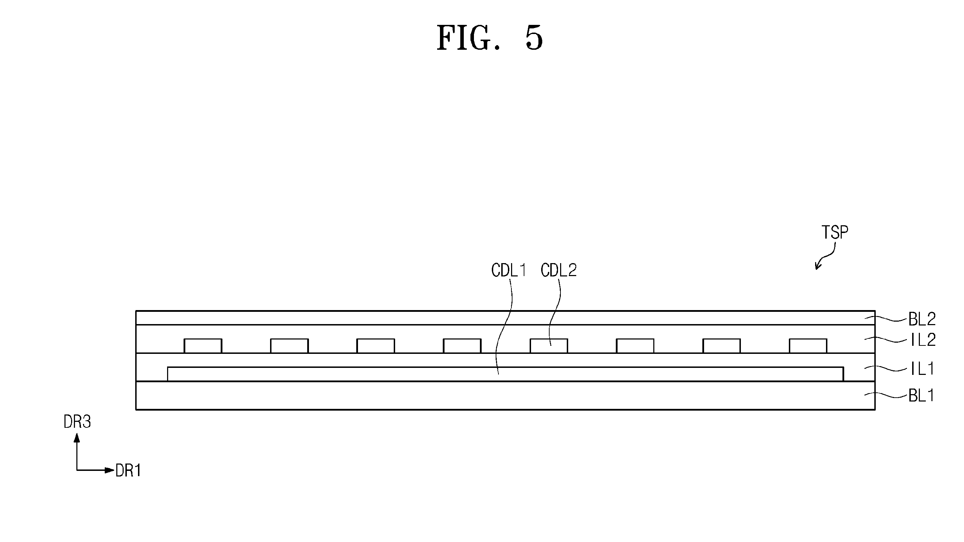

FIG. 5 is a cross-sectional view showing a touch panel according to an exemplary embodiment of the inventive concepts. FIG. 5 shows an electrostatic capacitive mode touch panel TSP as an example.

The electrostatic capacitive mode touch panel TSP includes a first base layer BL1, a first conductive layer CDL1, a first inner layer IL1, a second conductive layer CDL2, a second inner layer IL2, and a second base layer BL1. The first conductive layer CDL1, the first inner layer IL1, the second conductive layer CDL2, the second inner layer IL2, and the second base layer BL1, sequentially stacked on the first base layer BL1. The first and second base layers BL1 and BL2 may be plastic films. The first and second inner layers IL1 and IL2 may include an insulating material. The first and second conductive layers CDL1 and CDL2 may include a transparent conductive material.

Each of the first and second conductive layers CDL1 and CDL2 includes conductive patterns. The first conductive layer CDL1 includes conductive patterns extending in the first direction DR1 and arranged in the second direction DR2. The second conductive layer CDL2 includes conductive patterns extending in the second direction DR2 and arranged in the first direction DR1. The cross-sectional view of FIG. 5 shows one conductive pattern included in the first conductive layer CDL1 and eight conductive patterns included in the second conductive layer CDL2 as an example.

The electrostatic capacitive mode touch panel TSP detects capacitance variation occurring when the user's finger or the electronic pen is located on the second base layer BL2, thereby obtaining the coordinates information of the input spot. The first conductive layer CDL1 and the second conductive layer CDL2 may include conductive patterns having other shapes according to a kind of the touch panel.

Referring again to FIGS. 1A and 1B, the stress control member AM physically couples the display panel DP to the outer member OSM. When the display device DD is bent, the stress control member AM may partially decouple the stress of the display panel DP from the stress of the outer member OSM. Thus, when the display device DD is bent, different neutral planes may be formed in the display panel DP and the outer member OSM, respectively.

The stress control member AM may be a pressure sensitive adhesive (PSA) sheet. The pressure sensitive adhesive sheet may include at least one of a polymer, a cross-linking agent, and a resin. The polymer may include at least one of acrylic polymers, silicon-based polymers, and urethane-based polymers.

The pressure sensitive adhesive sheet includes a portion having a relatively high viscosity and a portion having a relatively high elasticity in its thickness direction. An outer surface of the pressure sensitive adhesive sheet is formed of the portion having the high viscosity, and an inner layer of the pressure sensitive adhesive sheet is formed of the portion having the high elasticity. The stress control member AM is not limited to the pressure sensitive adhesive sheet. In an exemplary embodiment, the stress control member AM may be an adhesive member including an elastic inner layer and a viscous outer layer.

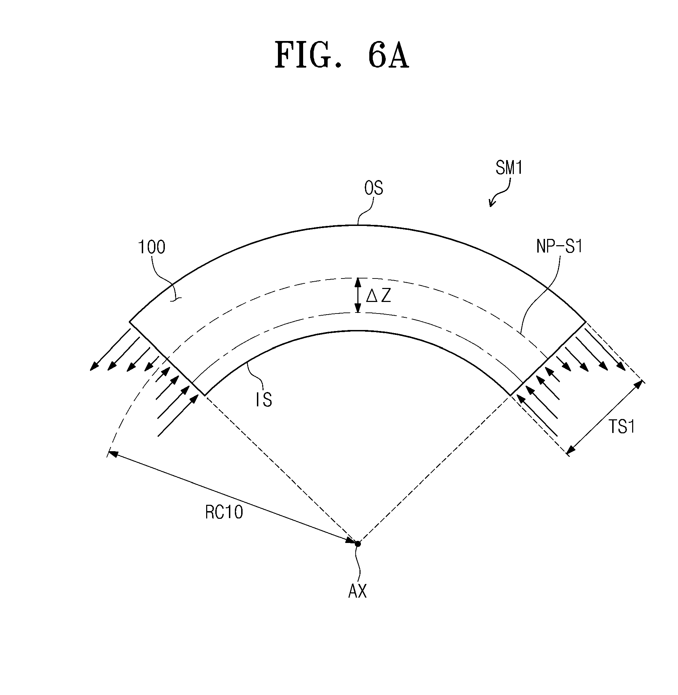

Hereinafter, the stress control member AM included in the display device DD according to the inventive concepts will be described with reference to FIGS. 6A, 6B, 7A, 7B, 7C, 8A, 8B, and 9A to 9E in detail.

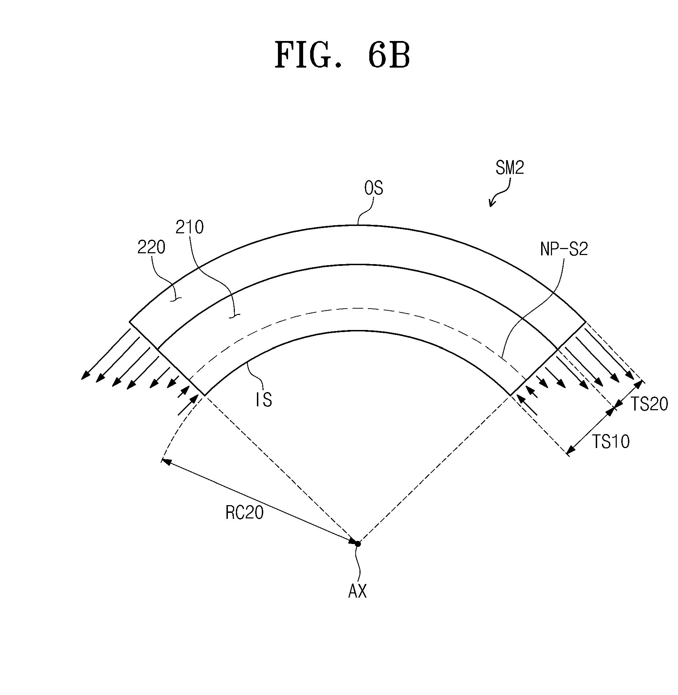

FIG. 6A is a side view showing a strain occurring in a member having a single layer when the single layered member is bent. FIG. 6B is a side view showing a strain occurring in a member having a double layer when the double layered member is bent.

FIG. 6A shows a member SM1 having a single layer 100. The member SM1 may be a display panel DD or an outer member OSM. The member SM1 has a predetermined thickness TS1. When the member SM1 is bent with a radius of curvature RC10, one neutral plane NP-S1 forms.

When the member SM1 is bent, a strain occurring in a spot spaced apart from the neutral plane NP-S1 by a distance $\Delta Z$ in its thickness direction may be expressed as following equation 1. If the spot spaced by the predetermined distance $\Delta Z$ is closer to an inner surface IS that the neutral plane NP-S1, a strain by a compressive stress (i.e., a compressive strain) occurs. On the other hand, if the spot spaced by the predetermined distance $\Delta Z$ is closer to an outer surface OS that the neutral plane NP-S1, a strain by a tensile stress (i.e., a tensile stress) occurs.

[Equation 1]

$$S = \frac{\pi(RC10 + \Delta Z) - \pi RC10}{\pi RC10} = \frac{\Delta Z}{RC10}$$

Thus, the compressive strain occurring at the inner surface IS and the tensile strain occurring at the outer surface OS may be expressed as following equation 2. The maximum strains may occur at the inner surface IS and the outer surface OS.

[Equation 2]

$$S = \frac{TS1}{2 \times RC10}$$

FIG. 6B is a side view showing a member SM2 having a double layer when the double layered member is bent. The member SM2 includes a first layer 210 and a second layer 220 disposed on the first layer 210. The second layer 220 may be coated or deposited on the first layer 210. The first layer 210 and the second layer 220 may be adhered to each other by a hard adhesive having a negligible viscosity or elasticity.

The first layer 210 and the second layer 220 have thicknesses of TS10 and TS20, respectively. The member SM2 is bent with a radius of curvature RC20. At this time, one neutral plane NP-S2 occurs in the member SM2. Even though the member SM2 has double layer, the member SM2 is analyzed as a single layer for purpose of stain. The strain occurring at the outer surface OS of the member SM2 may be expressed as the following equation 3 considering the thicknesses and modulus of the first layer 210 and the second layer 220.

[Equation 3]

$$S = \left\{ \frac{TS10 + TS20}{2 \times RC20} \right\} \times \left\{ \frac{1 + 2\eta + \chi\eta^2}{(1+\eta)(1+\chi\eta)} \right\}$$

In the equation 3, "$\eta$" is defined as a value obtained by dividing the thickness TS20 of the second layer 220 by the thickness TS10 of the first layer 210, and "$\chi$" is defined as a value obtained by dividing Young's modulus of the second layer 220 by Young's modulus of the first layer 210.

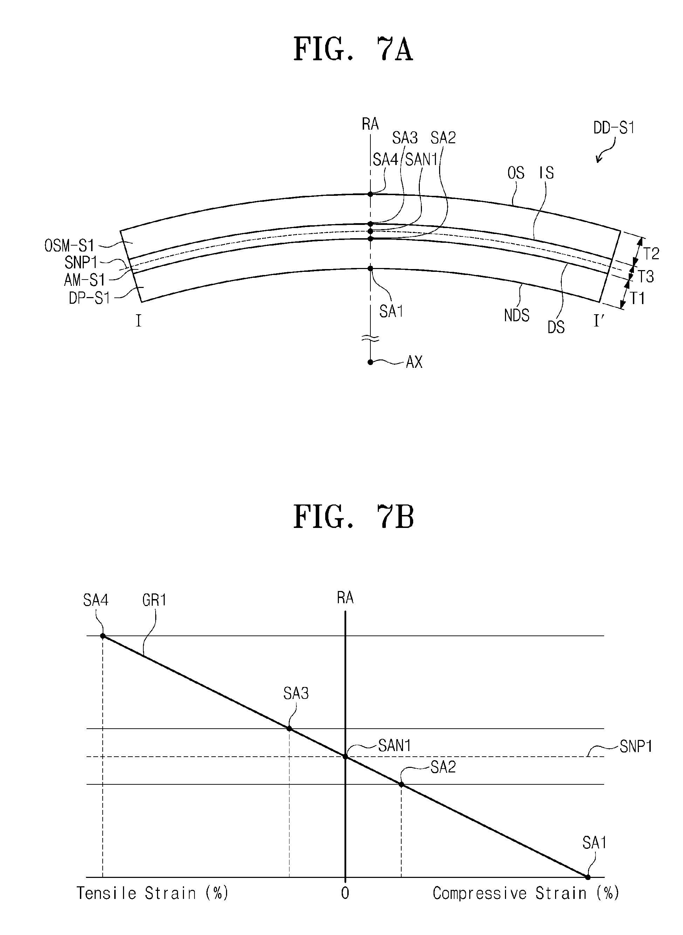

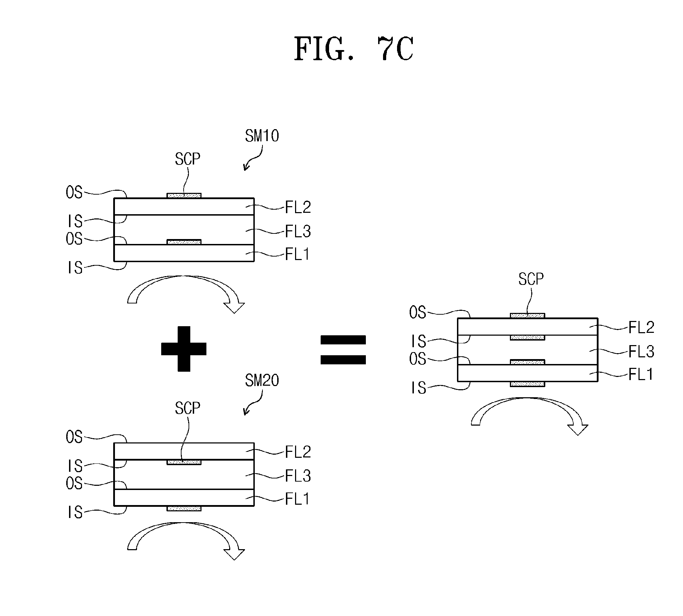

FIG. 7A is a side view showing a display device including members of which their stresses are coupled to each other when the display apparatus is bent. FIG. 7B is a graph showing a strain occurring in the display device shown in FIG. 7A. FIG. 7C is a view showing a method of measuring a strain occurring in a display device.

Referring to FIG. 7A, a display device DD-S1 includes a display panel DP-S1, an outer member OSM-S1, and an adhesive member AM-S1. The display panel DP-S1, the outer member OSM-S1, and the adhesive member AM-S1 have thicknesses of T1, T2, and T3, respectively. The display device DD-S1 is bent so that the display panel DP-S1 is disposed inside the bent display device DD-S1.

The adhesive member AM-S1 physically couples the display panel DP-S1 to the outer member OSM-S1. When the display device DD-S1 is bent, a stress of the display panel DP-S1 is coupled to a stress of the outer member OSM-S1 by the adhesive member AM-S1. Thus, one neutral plane SNP1 is formed in the display device DD-S1 when the display device DD-S1 is bent. FIG. 7A shows the neutral plane SNP1 defined within the adhesive member AM-S1 as an example. The neutral plane is an imaginary plane defined by spots of which strains are substantially zero (0). Due to an experimental error, the strain of substantial zero may be expanded to a range of +0.05 to -0.05 between a tensile strain and a compressive strain, considering experimental error.

A first graph GR1 in FIG. 7B represents the strain occurring in the display device DD-S1. The first graph GR1 includes strains occurring in five spots SA1, SA2, SA3, SA4, and SAN1. The five spots SA1, SA2, SA3, SA4, and SAN1 are disposed on a reference line RA which extends from a bending axis AX perpendicular to a display surface DS of the display panel DP-S1.

Since the adhesive member AM-S1 couples the stress of the display panel DP-S1 to the stress of the outer member OSM-S1, the strain occurring in the display device DD-S1 according to its thickness may be represented by the equation 1 or the equation 3. The strain occurring in the display device DD-S1 may be similar to a strain occurring in one member.

The first spot SA1 disposed at a non-display surface NDS of the display panel DP-S1 has a the maximum strain occurring by a compressive stress (i.e., the maximum compressive strain), and the fourth spot SA4 disposed at an outer surface OS of the outer member OSM-S1 has the maximum strain occurring by a tensile stress (i.e., the maximum tensile strain). The second spot SA2 disposed at a display surface DS of the display penal DP-S1 has a compressive strain smaller than that of the first spot SA1, and the third spot SA3 disposed at an inner surface IS of the outer member OSM-S1 has a tensile strain smaller than that of the fourth spot SA4. No substantial strain occurs in the fifth spot SAN1.

The first graph GR1 of FIG. 7B shows the strain linearly changed from the first spot SA1 to the fourth spot SA4. Non-linear sections may be disposed between the five spots SA1, SA2, SA3, SA4, and SAN1 when each of the display panel DP-S1 and the outer member OSM-S1 includes a plurality of layers having different material properties from each other.

The strains occurring in the four spots SA1, SA2, SA3, and SA4 may be measured by a method shown in FIG. 7C. The strain may be measured using first and second members SM10 and SM20, each including a first function layer FL1, a second function layer FL2, and a third function layer FL3, that have material properties similar to those of the display panel DP-S 1, the outer member OSM-S 1, and the adhesive member AM-S 1, respectively.

The first member SM10 includes a silicon pattern SCP disposed on each outer surface OS of the first and second function layers FL1 and FL2. The second member SM20 includes a silicon pattern SCP disposed on each inner surfaces IS of each of the first and second function layers FL1 and FL2.

If the first and second members SM10 and SM20 are bent, the silicon patterns SCP may have different resistance values from a piezo-resistance effect of silicon. The resistance of a P-type silicon pattern decreases when the compressive stress is applied, and the resistance of the P-type silicon pattern increases when the tensile stress is applied. The resistance of an N-type silicon pattern increases when the compressive stress is applied, and the resistance of the N-type silicon pattern decreases when the tensile stress is applied.

When the first and second members SM10 and SM20 are bent, the resistance values of the silicon patterns SCP are measured to calculate the strains occurring in the four spots SA1, SA2, SA3, and SA4.

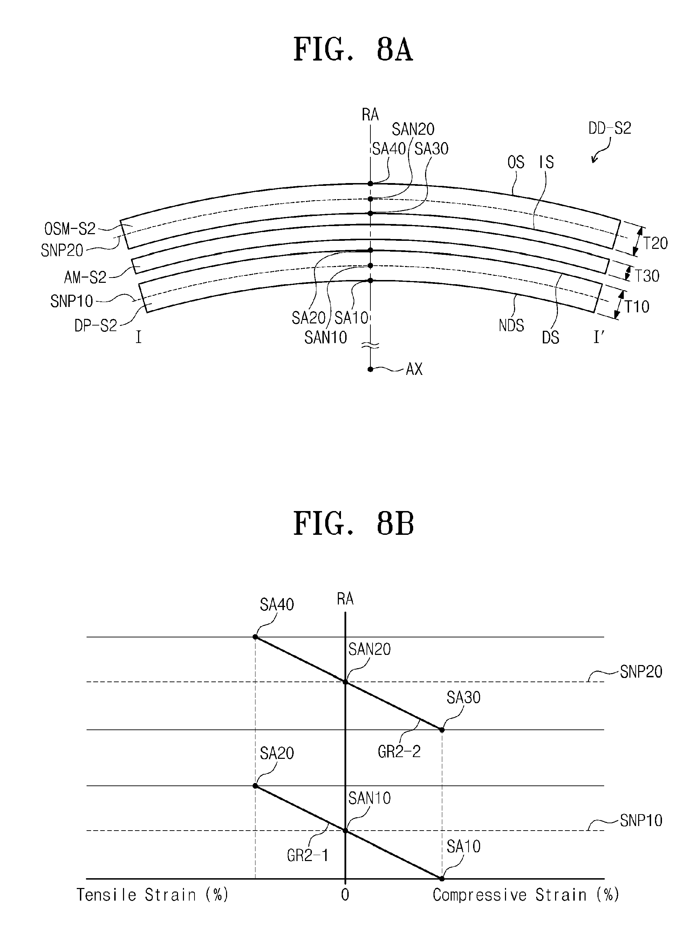

FIG. 8A is a side view showing a display device including members of which stresses are decoupled from each other when the display device is bent. FIG. 8B is a graph showing a strain occurring in the display device shown in FIG. 8A.

As shown in FIG. 8A, a display device DD-S2 includes a display panel DP-S2, an outer member OSM-S2, and an adhesive member AM-S2. The display panel DP-S2, the outer member OSM-S2, and the adhesive member AM-S2 have thicknesses of T10, T20, and T30, respectively.

When the display device DD-S2 is bent, the adhesive member AM-S2 decouples a stress of the display device DD-S2 from a stress of the outer member OSM-S2. Thus, neutral planes SNP10 and SNP20 can be respectively defined or formed in the display panel DD-SP and the outer member OSM-S2 when the display device DD-S2 is bent. Each of the display panel DP-S2 and the outer member OSM-S2 has a strain expressed by the equation 1 or 3, and the strains of the display panel DP-S2 and the outer member OSM-S2 are independent of each other. In other words, the strains occurring in the display panel DP-S2 and the outer member OSM-S2 are only affected by their respective thicknesses.

Second graphs GR2-1 and GR2-2 of FIG. 8B represent the strains occurring in the display device DD-S2. In the event that the thickness T10 of the display panel DP-S2 is similar to the thickness T20 of the outer member OSM-S2, a first spot SA10 and a third spot SA30 may have compressive strains of similar intensities, and a second spot SA20 and a fourth spot SA40 may have tensile strains of similar intensities.

However, the adhesive member AM-S2 does not physically couple the display panel DP-S2 to the outer member OSM-S2. Thus, the display panel DP-S2 and the outer member OSM-S2 become physically separated from the adhesive member AM-S2 when the display panel DD-S2 is bent.

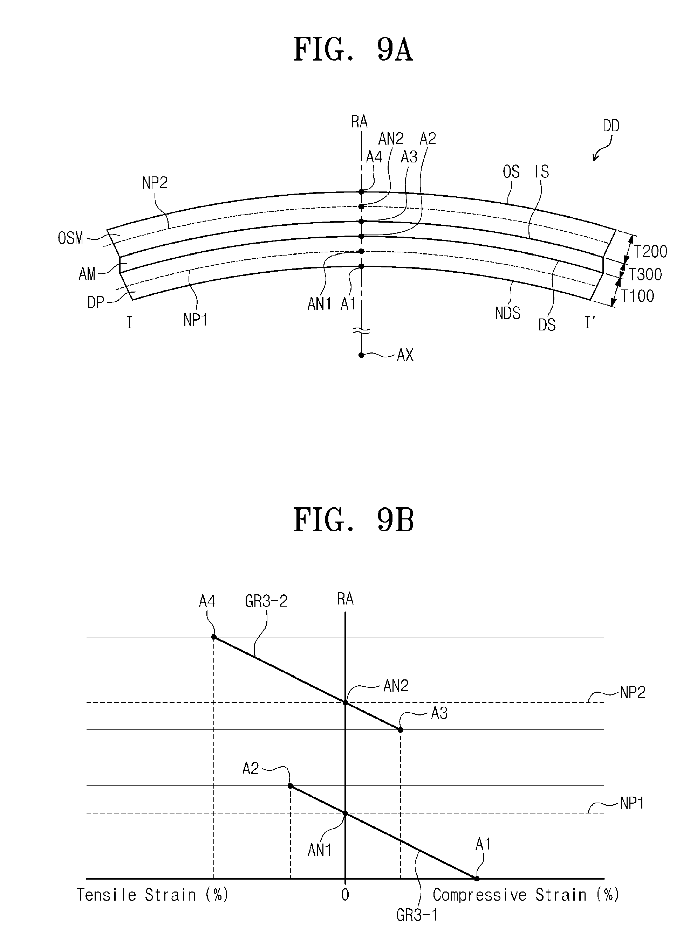

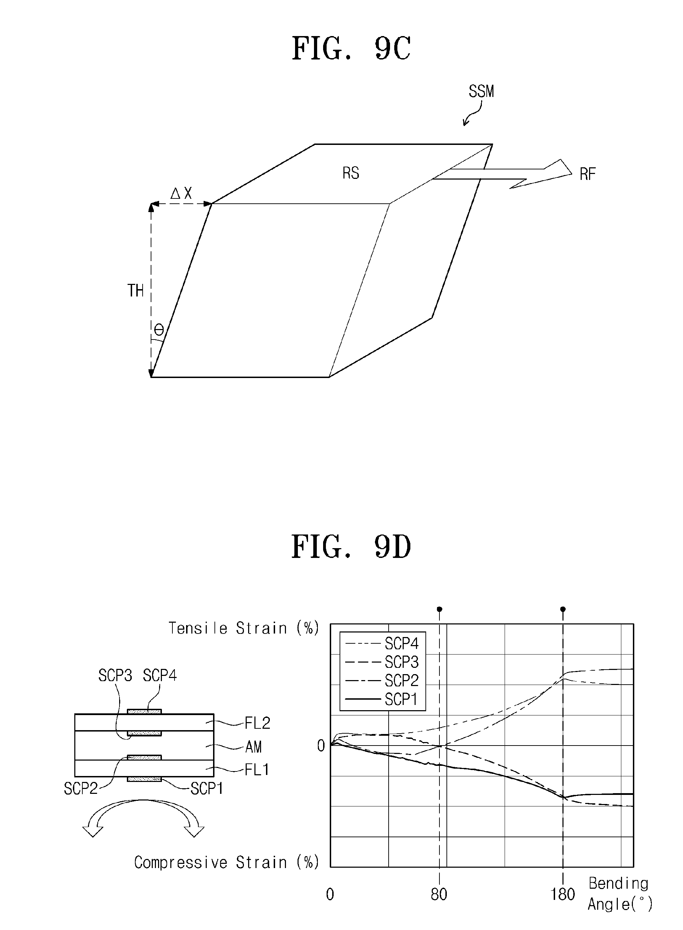

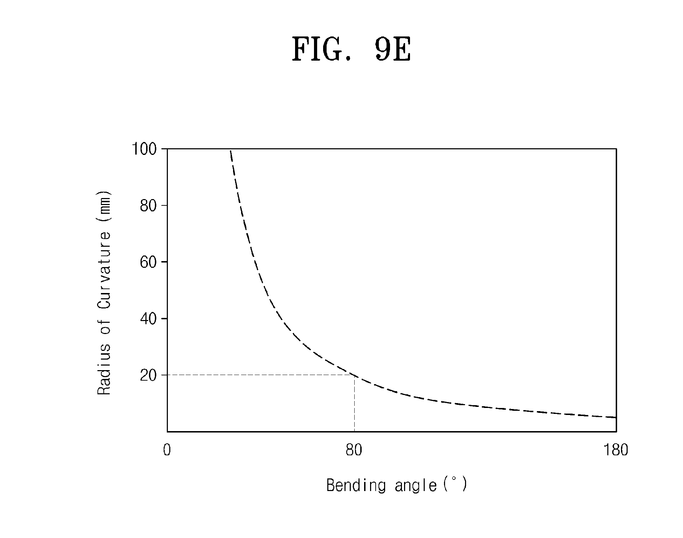

FIG. 9A is a cross-sectional view showing a display device according to an exemplary embodiment of the inventive concepts. FIG. 9B is a graph showing a strain occurring in the display device shown in FIG. 9A. FIG. 9C is a perspective view showing relation between a shear stress and a shear strain. FIG. 9D is a view showing a method of measuring a shear strain of a stress control member of the display device of FIG. 9A. FIG. 9E is a graph showing a radius of curvature according to a bending angle. As shown in FIG. 9A, a display device DD according to an exemplary embodiment of the inventive concepts includes a display panel DP, an outer member OSM, and a stress control member AM. The display panel DP, the outer member OSM, and the stress control member AM have thicknesses of T100, T200, and T300, respectively. When the display device DD is bent, the stress control member AM physically couples the display panel DP and the outer member OSM to each other.

When the display device DD is bent, the stress control member AM partially decouples a stress of the display panel DP and a stress of the outer member OSM from each other. Neutral planes NP1 and NP2 are defined in the display panel DP and the outer member OSM, respectively, when the display device DD is bent.

Third graphs GR3-1 and GR3-2 of FIG. 9B represent strains occurring in the display device DD. The third graphs GR3-1 and GR3-2 include strains occurring in six spots A1, A2, A3, A4, AN1, and AN2. The six spots A1, A2, A3, A4, AN1, and AN2 are disposed on a reference line RA extending from a bending axis AX and is perpendicular to a display surface DS of the display panel DP.

Since the stress of the display panel DP is partially decoupled from the stress of the outer member OSM, a strain of the display surface of the display panel DP occurs by one of a compressive stress and a tensile stress, and a strain of an inner surface IS of the outer member OSM occurs by the other of the compressive stress and the tensile stress. A tensile strain occurs in the second spot A2 disposed on the display surface DS of the display panel DP, and a compressive strain occurs in the third spot A3 disposed on the inner surface IS of the outer member OSM.

The strain at the display surface DS of the display panel DP occurs by either one of the compressive stress or the tensile stress, and a strain ata non-display surface NDS of the display panel DP occurs by the other one of the compressive stress or the tensile stress. If a tensile strain occurs in the second spot A2 disposed on the display surface DS, then a compressive strain occurs in the first spot A1 disposed on the non-display surface.

The strain at the inner surface IS of the outer member OSM occurs by either one of the compressive stress or the tensile stress, and a strain at an outer surface OS of the outer member OSM occurs by the other one of the compressive stress or the tensile stress. If a compressive strain occurs in the third spot A3 disposed on the inner surface IS, a tensile strain occurs in the fourth spot A4 disposed on the outer surface OS of the outer member OSM. Substantial strains do not occur in the fifth and sixth spots AN1 and AN2.

Since the outer member OSM is disposed outside the bent display device DD and the display panel DP is disposed inside the bent display device DD, the tensile strain occurring in the fourth spot A4 is greater than the tensile strain occurring in the second spot A2. For the same reason, the compressive strain occurring in the first spot A1 is greater than the compressive strain occurring in the third spot A3. If the display device is bent in a direction opposite to the bending direction shown in FIG. 9A, a greater compressive strain occurs in the outer member OSM than in the display panel DP.

If four spots A1, A2, A3, and A4 of FIGS. 9A and 9B are compared with the four spots SA1, SA2, SA3, and SA4 of FIGS. 7A and 7B, the occurring strains of the display device DD according to an exemplary embodiment of the inventive concepts are smaller than those of the display device DD-S1 shown in FIGS. 7A and 7B. More specifically, the first spot A1 of FIG. 9B has a smaller compressive strain than that of the first spot SA1 of FIG. 7B, and the fourth spot A4 of FIG. 9B has a smaller tensile strain than that of the fourth spot SA4 of FIG. 7B corresponding thereto. This is because the neutral planes NP1 and NP2 are formed in the display panel DP and the outer member OSM of the display device DD according to the exemplary embodiment, respectively.

Strains occurring in internal components of the display panel DP and the outer member OSM of FIGS. 9A and 9B are smaller than strains occurring in internal components of the display panel DP-S1 and the outer member OSM-S1 of FIGS. 7A and 7B. A strain affecting the thin film transistor TR-D or the organic light emitting diode OLED of FIG. 4 is reduced,and therefore, damage to the thin film transistor TR-D and the organic light emitting diode OLED may also be reduced.

When the display device DD according to an exemplary embodiment of the inventive concepts is bent, the strain that occurs in the display device DD is a little greater than that in the display device DD-S2 of FIG. 8A and 8B. The first spot A1 of FIG. 9B has a little greater compressive strain than that of the first spot SA10 of FIG. 8B, and the fourth spot A4 of FIG. 9B has a little greater tensile strain than that of the fourth spot SA40 of FIG. 8B. However, the stress control member AM according to an exemplary embodiment of the inventive concepts may maintain the display panel DP and the outer member OSM physically coupled to each other even when the display device DD is bent. Thus, it is possible to prevent the problem that the display panel DP-S2 and the outer member OSM-S2 are physically separated from the adhesive member AM-S2, as described with reference to FIG. 8A.

Referring to FIG. 9C, a shear stress occurs within the stress control member AM when the display device DD is bent. The shear stress K is represented by the following equation 4. In the following equation 4, "RS" is defined as an area of a corresponding member SSM, and "RF" is defined as a force applied to the corresponding member SSM when the corresponding member SSM is bent.

[Equation 4]

$$K = \frac{RS}{RF}$$

The stress control member AM may be deformed from the shear stress corresponding to a shear modulus. A deformation rate of the stress control member AM may be represented by a shear strain. The shear strain SS is expressed by the following equation 5. In the following equation 5, "TH" is defined as a thickness of the corresponding member SSM, and "ΔX" is defined as a displacement occurring in a direction parallel to a direction the force RF applied to the corresponding member SSM.

[Equation 5]

$$SS = \frac{\Delta X}{TH}$$

The shear strain SS is equal to a tan θ. The θ is an angle shown in FIG. 9C.

Since the stress control member AM is deformed when the shear stress us applied corresponding to its shear strain, the compressive stress and the tensile stress of the display panel DP may be partially decoupled from those of the outer member OSM, as described with reference to FIGS. 9A and 9B.

A shear strain range of the stress control member AM will be described with reference to FIGS. 9D and 9E.

As shown in FIG. 9D, the shear strain of the stress control member AM, which occurs when the stress control member AM is bent, may be measured using a member including the stress control member AM and first and second function layers FL1 and FL2. The first and second function layers FL1 and FL2 have material properties similar to those of the display panel DP and the outer member OSM, respectively. The strains of the first and second function layers FL1 and FL2 may be measured using the method described with reference to FIG. 7C, and a bending angle at which the neutral plane is defined may be calculated in consideration of variation of the strain. The displacement ΔX of the stress control member AM may be measured when the neutral plane is defined.

According to graphs shown in FIG. 9D, the neutral planes are respectively defined in the first and second function layers FL1 and FL2 at the bending angle of about 80 degrees. At the bending angle of about 80 degrees, a strain measured by a silicon pattern SCP2 disposed on a upper surface of a top surface of the first function layer FL1 is reversed from a compressive strain to a tensile strain and, a strain measured by a silicon pattern SCP3 disposed on a bottom surface of the second function layer FL2 is reversed from a tensile strain to a compressive strain.

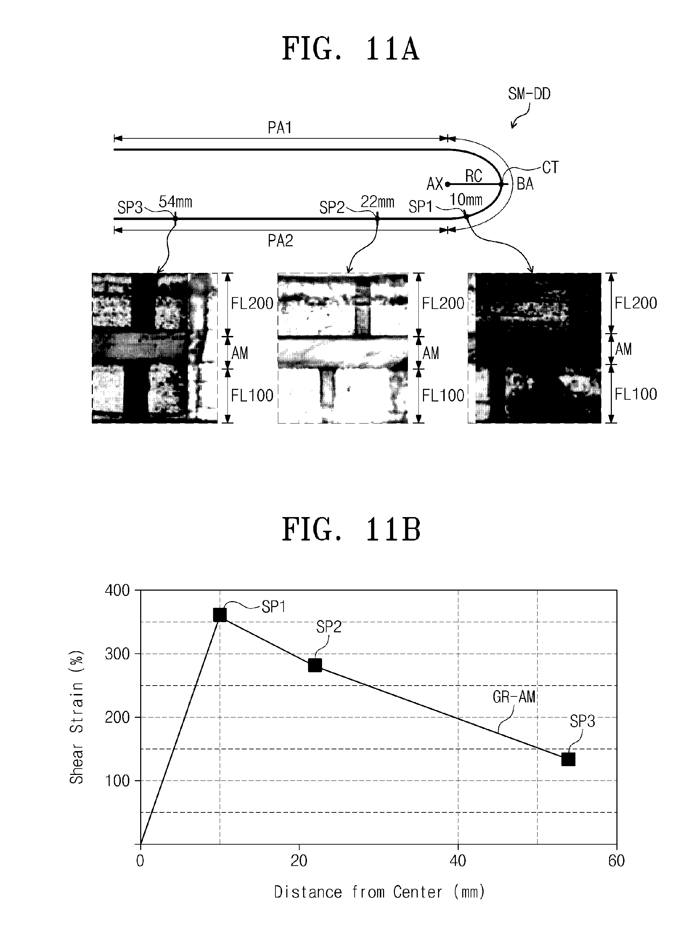

Referring to FIG. 9E, the bending angle may be converted into a radius of curvature. The bending angle of about 80 degrees corresponds to the radius of curvature of about 20 mm. In this case, the measured shear strain of the stress control member AM is about 170%, as shown in the following table 1. The shear strain of 170% is the maximum shear strain occurring at the bending angle of about 80 degrees. The shear strain occurring at the bending angle of about 80 degrees may be varied depending on a distance from a bending center CT shown in FIG. 11A.

A unit of measure of the shear strain is %. The shear strain of 100% means that the displacement ΔX of the stress control member AM is equal to the thickness of the stress control member AM. Additionally, the stress control member AM has the shear strain of about 289% at the bending angle of about 180 degrees at the radius of curvature of about 3 mm. Values shown in the following table 1 are mean values obtained by performing a plurality experiments, and the experimental error is about 10%.

[Table 1]

| Bending angle (°) | 80 | 90 | 120 | 180 | 180 |
|---|---|---|---|---|---|
| Radius of curvature (mm) | 20 | 16 | 10 | 5 | 3 |
| Maximum shear strain (%) | 170 | 178 | 213 | 271 | 289 |
| Distance from bending center (mm) | 34 | 34 | 18 | 8 | 6 |

The bending angle and the radius of curvature may be varied according to an exemplary embodiment of the flexible display device. According to an exemplary embodiment, when the flexible display device may be bent at the bending angle of 180 degrees with the radius of curvature of about 20 mm, the strain occurring in the stress control member AM may be about 170%. Thus, the table 1 may be expanded to another bending angle at the corresponding radius of curvature

As a result, the stress control member AM has the maximum shear strain of at least about 150% at the radius of curvature of about 20 mm or less in order to partially decouple the compressive stresses and the tensile stresses of adjacent members from each other. The maximum shear strain is a value in consideration of the experimental error.

When the display device DD is bent, the display panel DP and the outer member OSM may be plastically deformed. This means that the display device DD is damaged. A strain that may plastically deform the display panel DP and the outer member OSM is defined as a limit shear strain. Generally, the outer member OSM (e.g., the touch panel, the optical member, the window member, or the protecting member) as well as the display panel DP may have a limit shear strain of about 10%.

In order to avoid the limit shear strain from occurring in the display pane DP and the outer member OSM when the display device DD is bent, a bent portion of the stress control member AM where the maximum shear strain occurs may have a shear strain of about 150% or more. The stress control member AM may be sufficiently deformed to partially decouple the stress of the display panel DP from the stress of the outer member OSM.

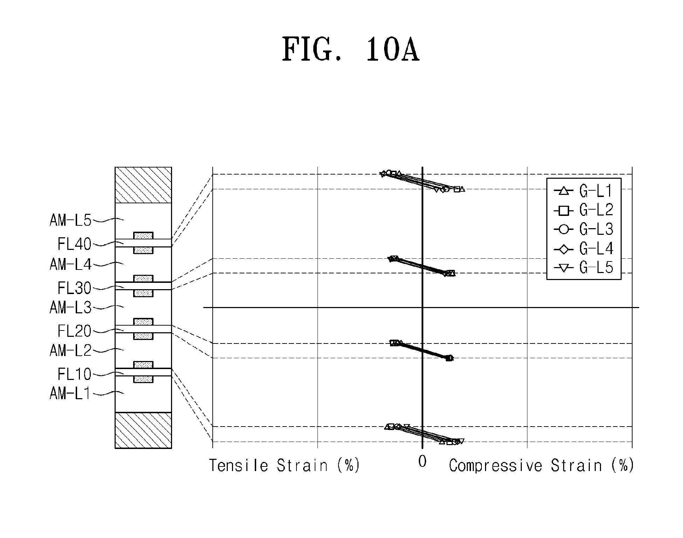

The shear strain of the stress control member AM may be determined depending on the shear modulus of the stress control member AM and the shear stress applied to the stress control member AM when the stress control member AM is bent. The shear modulus may be determined depending on compositions included in the stress control member AM and ratios of the compositions. The shear stress applied to the stress control member AM may also be determined depending on the thickness and the radius of curvature of the display device DD. Additionally, the shear strain of the stress control member AM may be affected by a bending speed. Hereinafter, determinants of the shear strain will be described with reference to FIGS. 10A to 10C in more detail.

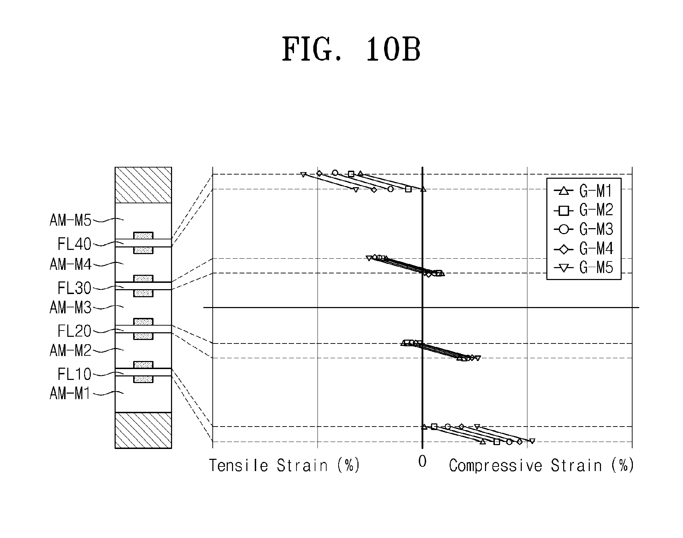

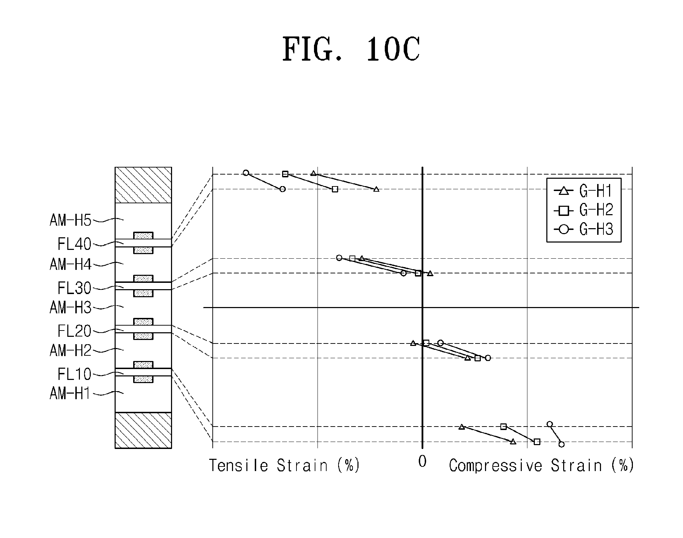

FIGS. 10A, 10B, and 10C are graphs showing strains according to a modulus and a bending speed of a stress control member. The graphs shown in FIGS. 10A, 10B, and 10C represent strains of experimental members of which each includes five stress control members with four function layers FL10 to FL40 respectively disposed there between. The graphs shown in FIGS. 10A, 10B, and 10C represent strains measured at the same radius of curvature.

First to fifth graphs G-L1, G-L2, G-L3, G-L4, and G-L5 of FIG. 10A represent strains corresponding to bending speeds of an exemplary experimental member including stress control members AM-L1 to AM-L5 with low modulus. The modulus of the stress control members AM-L1 to AM-L5 may be, for example, 600MPa. The bending speed is determined according to an angle changed per second. The first to fifth graphs G-L1, G-L2, G-L3, G-L4, and G-L5 represent strains of experimental members respectively bent at bending speeds of 10 degrees per second, 18 degrees per second, 45 degrees per second, 90 degrees per second, and 180 degrees per second.

First to fifth graphs G-M1, G-M2, G-M3, G-M4, and G-M5 of FIG. 10B represent strains corresponding to bending speeds of an exemplary experimental member including stress control members AM-M1 to AM-with a middle modulus. The modulus of the stress control members AM-M1 to AM-M5 may be, for example, 800MPa. The first to fifth graphs G-M1, G-M2, G-M3, G-M4, and G-M5 represent strains of experimental members respectively bent at bending speeds of 10 degrees per second, 18 degrees per second, 45 degrees per second, 90 degrees per second, and 180 degrees per second.

First to third graphs G-H1, G-H2, and G-H3 of FIG. 10C represent strains corresponding to bending speeds of an exemplary experimental member including stress control members AM-H1 to AM-H5 with high modulus. The modulus of the stress control members AM-H to AM-H5 may be, for example, 1000MPa. The first to third graphs G-H1, G-H2, and G-H3 represent strains of experimental members respectively bent at bending speeds of 10 degrees per second, 18 degrees per second, and 45 degrees per second.

Referring to FIG. 10A, the stress control members AM-L1 to AM-L5 with low modulus generate neutral planes in the adjacent function layers FL10 to FL40 regardless of their positions and bending speed. Portions, in which the maximum shear strains occur, of bent portions of the stress control members AM-L1 to AM-L5 have the shear strain of about 150% or more.

Referring to FIG. 10B, some of the stress control members AM-M1 to AM-M5 with middle modulus may define neutral planes in the adjacent function layers according to their positions. Only a stress control member AM-M3 disposed in the center of the stress control members AM-M1 to AM-M5 generated neutral planes in the adjacent function layers FL20 and FL30 regardless of the bending speed. A portion, in which the maximum shear strain occurs, of a bent portion of the centered stress control member AM-M3 has the shear strain of about 150% or more.

Referring to FIG. 10C, the stress control members AM-H1 to AM-H5 with high modulus may define neutral planes in the adjacent function layers according to their bending speed as well as their positions. Only a stress control member AM-H3 disposed in the center of the stress control members AM-H1 to AM-H5 generated the neutral planes in the adjacent function layers FL 20 and 30 at the bending speed of 10 degrees per second. A portion, in which the maximum shear strain occurs, of a bent portion of the centered stress control member AM-H3 has the shear strain of about 150% or more at the bending speed of 10 degrees per second.

FIG. 11A is an image showing a cross-section of a bent exemplary experimental member. FIG. 11B is a graph showing a strain occurring in an experimental member shown in FIG. 11A.

An experimental member SM-DD shown in FIG. 11A includes a first function layer FL100, a second function layer FL200, and a stress control member AM disposed there between. The first function layer FL100 and the second function layer FL200 have material properties similar to those of the display panel DP and the outer member OSM, respectively.

The experimental member SM-DD is bent at certain area. When the experimental member SM-DD is bent, it may be divided into a bent area BA, a first planar area PA1, and a second planar area PA2.

FIG. 11A shows images of three spots SP1, SP2, and SP3 spaced apart from a center spot CT of the bent area BA. A first spot SP1 is spaced apart from the center spot CT by 10 mm, and a second spot SP2 is spaced apart from the center spot CT by 22 mm. A third spot SP3 is spaced apart from the center spot CT by 54 mm. Among the three spots SP1, SP2, and SP3, the greatest shear strain occurs in the first spot SP1, and the smallest shear strain occurs in the third spot SP3.

According to a graph GR-AM shown in FIG. 11B, the greatest shear strain occurs in the first spot SP1. When the experimental member SM-DD is bent, the maximum shear strain of the stress control member AM in the first spot SP1 is about 360%, which is greater than 150% described above. When the experimental member SM-DD is bent, the stress control member AM maintains the first function layer FL100 and the second function FL200 physically coupled to each other and partially decouples the stress of the first function FL100 from the stress of the second function layer FL200. Even though not shown in the drawings, the neutral planes are defined in the first function layer FL100 and the second function layer FL200 in the bent area BA, respectively.

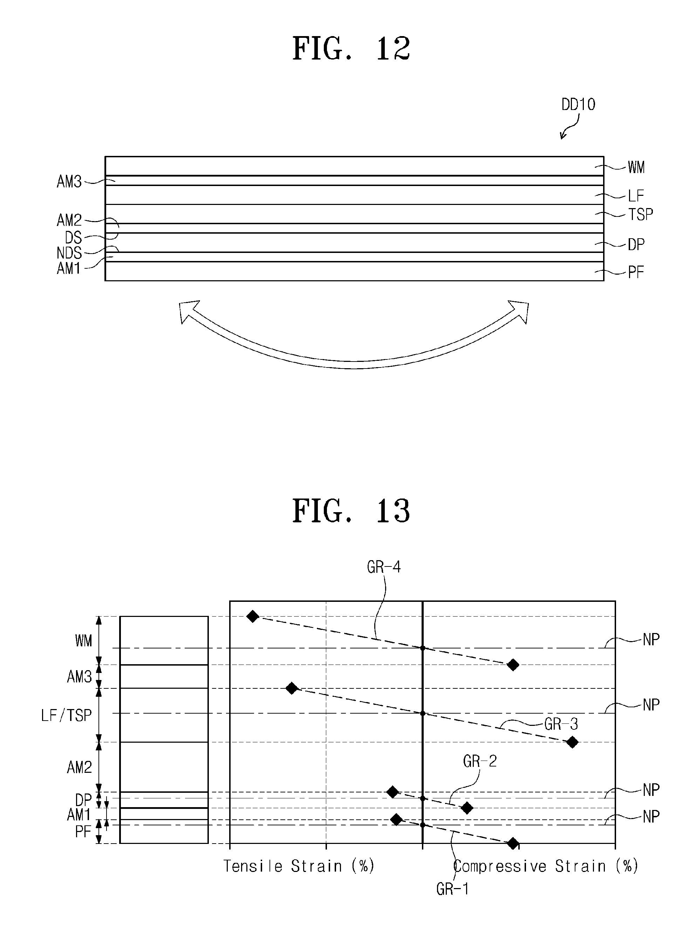

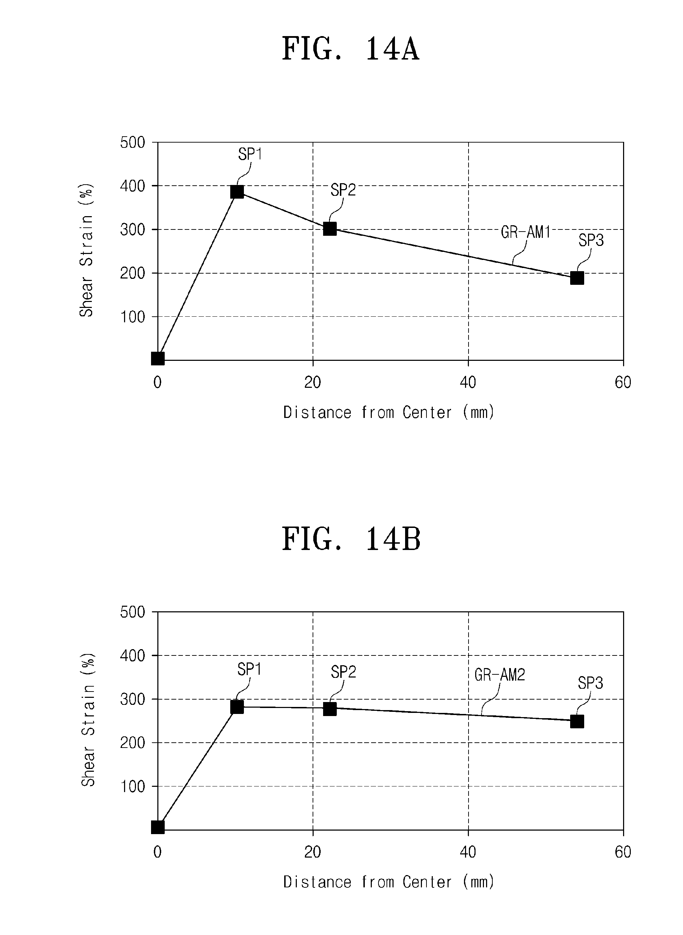

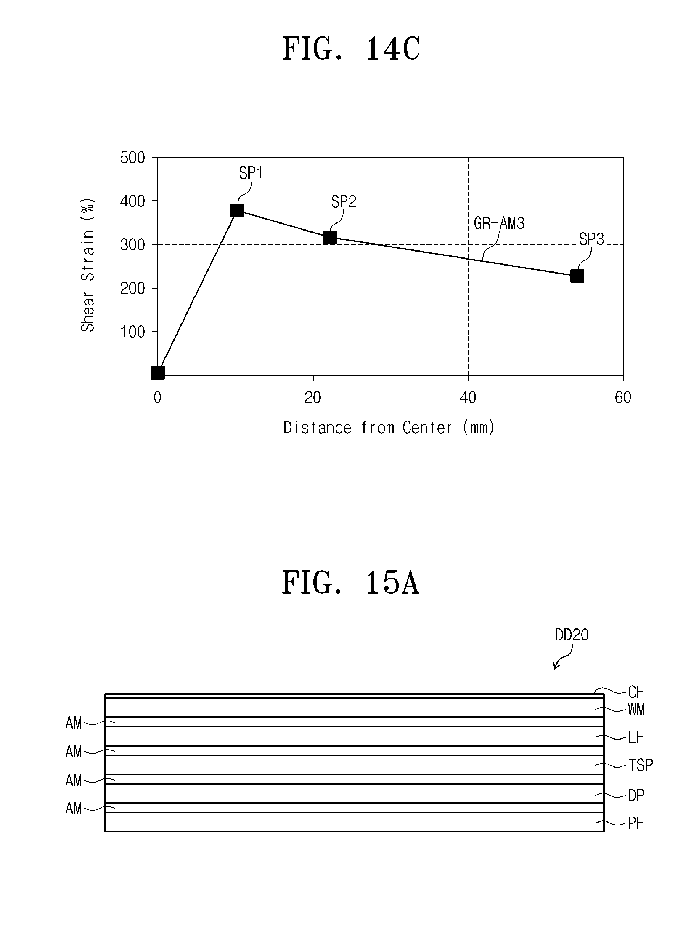

FIG. 12 is a side view showing a display device according to an exemplary embodiment of the inventive concepts. FIG. 13 is a graph showing a strain occurring in the display device shown in FIG. 12. FIGS. 14A, 14B, and 14C are graphs showing shear strains of stress control members shown in FIG. 12. Hereinafter, a display device according to the exemplary embodiment will be described with reference to FIGS. 12, 13, 14A, 14B, and 14C. In the exemplary embodiment, the descriptions to the same elements as described with reference to FIGS. 1 to 11B will be omitted or mentioned briefly for the purpose of ease and convenience in explanation.

Referring to FIG. 12, a display device DD10 includes a display panel DP, a protecting member PF disposed on a non-display surface NDS of the display panel DP, a touch panel TSP, an optical member LF, and a window member WM. The touch panel TSP, the optical member LF, and the window member WM are sequentially stacked on a display surface DS of the display panel DP.

The protecting member PF may be a flexible plastic film. The protecting member PF may have a multi-layered structure. The optical member LF may include a polarization member and a phase difference compensation member. The window member WM may include at least one of a flexible plastic film and a thin glass substrate. The window member WM may have a multi-layered structure.

The touch panel TSP and the optical member LF may be combined with each other by a hard adhesive. In an exemplary embodiment, the optical member LF may be replaced with the second base layer BL2 of FIG. 5. In other words, the touch panel TSP and the optical member LF may be combined to form a single touch panel layer.

Each of the first to third stress control members AM1, AM2, and AM3 is respectively disposed between the protecting member PF, the display panel DP, the touch panel layer, and the window member WM. Each of the first to third stress control members AM1, AM2, and AM3 physically couples two adjacent members. Additionally, each of the first to third stress control members AM1, AM2, and AM3 may partially decouple the stresses of the two adjacent members from each other. Functions of each of the first to third stress control members AM1, AM2, and AM3 to the adjacent two members are the substantially the same as those of the stress control member AM described with reference to FIGS. 9A, 9B, and 9C.

When the display device DD10 is bent such that different portions of the window member WM face each other, strains of graphs GR-1, GR2, GR-3, and GR-4 of FIG. 13 occur in the display device DD10. When the display device DD10 is bent, neutral planes NP occurs in the protecting member PF, the display panel DP, the touch panel layer, and the window member WM, respectively.

The maximum compressive strains and the maximum tensile strains occurring in the protecting member PF, the display panel DP, the touch panel layer, and the window member WM may have different values according to their thicknesses.

The graphs GR-1, GR2, GR-3, and GR-4 represent strains of members having thicknesses described below. A thickness of the protecting member PF is 50 $\mu$m, and a thickness of the display panel DP is 33 $\mu$m. A thickness of the touch panel layer is 112 $\mu$m, and a thickness of the window member WM is 100 $\mu$m. Thicknesses of the first to third stress control members AM1, AM2, and AM3 are 25 $\mu$m, 10 $\mu$m, and 50 $\mu$m, respectively.

A graph GR-AM1 in FIG. 14A represents shear strains of the first stress control member AM1, and a graph GR-AM2 in FIG. 14B represents shear strains of the second stress control member AM2. A graph GR-AM3 in FIG. 14C represents shear strains of the third stress control member AM3. Each of the graphs GR-AM1, GR-AM2, and GR-AM3 represents shear strains of spots corresponding to the first to third spots SP1, SP2, and SP3 with reference to FIG. 11A.

According to the graphs GR-AM1, GR-AM2, and GR-AM3, the greatest shear strain occurs in the first spot SP1. Each of the maximum shear strains of the first to third stress control members AM1, AM2, and AM3 has a value of 150% or more when the display device DD10 is bent. Thus, the protecting member PF, the display panel DP, the one united optical member LF and touch panel TSP, and the window member WM may not be damaged when the display device DD10 is bent.

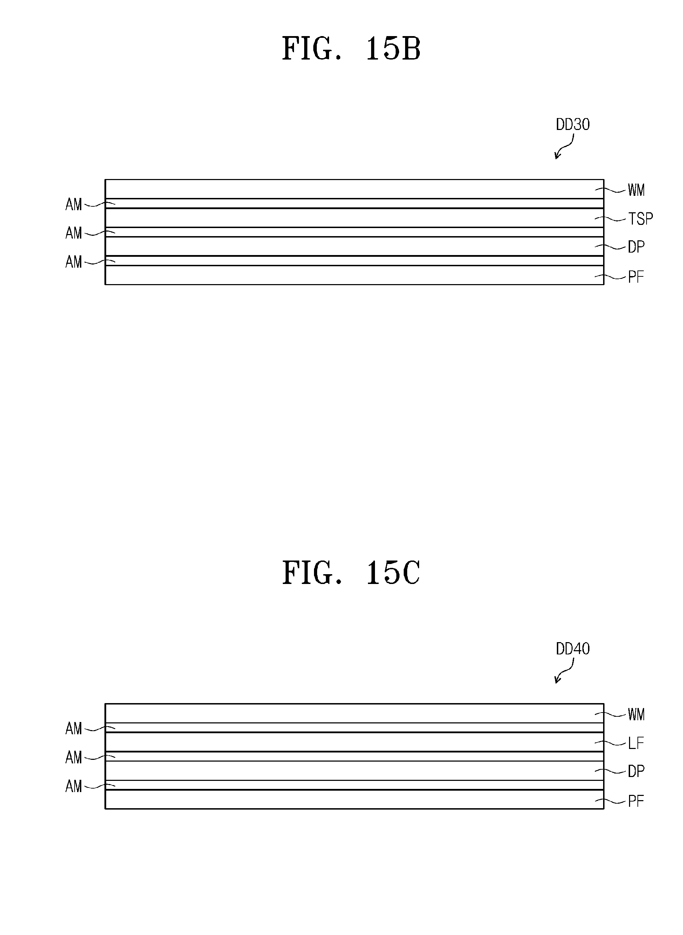

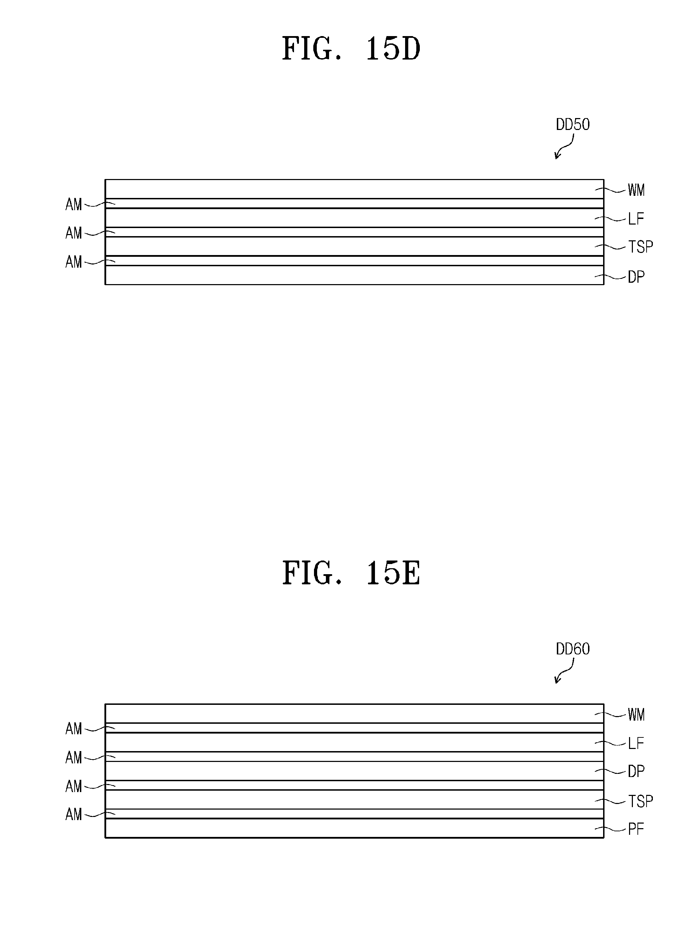

FIGS. 15A, 15B, 15C, 15D, and 15E are side views showing display devices according to some exemplary embodiments of the inventive concepts. Display devices of FIGS. 15A, 15B, 15C, 15D, and 15E have stack structures different from that of the display device of FIG. 12. Hereinafter, the stack structures of the display devices will be mainly described with reference to FIGS. 15A, 15B, 15C, 15D, and 15E. In the following exemplary embodiments, the descriptions to the same elements as described with reference to FIGS. 1 to 14C will be omitted or mentioned briefly for explanation purpose.

A display device DD20 of FIG. 15A may further include a stress control member AM disposed between the touch panel TSP and the optical member LF. Additionally, the display device DD20 may further include a functional layer CF coated on a top surface of the window member WM. The functional layer CF may include at least one of an anti-finger coating layer, an anti-reflection coating layer, an anti-glare coating layer, and a hard coating layer.

The optical member LF may be omitted, referring to a display device DD30 shown in FIG. 15B. The touch panel TSP may be omitted, referring to a display device DD40 shown in FIG. 15C. The protecting member PF may be omitted, referring to a display device DD50 shown in FIG. 15D. The touch panel TSP may be disposed between the protecting member PF and the display panel DP, referring a display device DD60 shown in FIG. 15E.

As described above, different neutral planes may be defined in the flexible display panel and the flexible outer member when the flexible display device is bent. This is because the stress of the flexible display panel is partially decoupled from the stress of the flexible outer member by the stress control member when the flexible display device is bent.

The strains occurring in the display panel and the flexible outer member have values corresponding to their thicknesses when the flexible display device is bent. The value corresponding to the thickness of each of the display panel and the flexible outer member or a little greater value than the value is smaller than a value corresponding to the thickness of the flexible display device. Thus, even though the flexible display device is bent, it is possible to reduce the damage to the internal components (e.g., the thin film transistor, the organic light emitting diode, and a conductive layer) of the flexible display panel and the flexible outer member.

**Claims**

1. A flexible display device, comprising:

   a flexible display panel;
   a flexible outer member disposed on the flexible display panel; **characterized by** the following features: a stress control member disposed between the flexible display panel and the flexible outer member,
   wherein the stress control member is configured to define a first neutral plane and a second neutral plane in the flexible display panel and the flexible outer member, respectively, when the flexible display device is bent.

2. The flexible display device of claim 1, wherein the stress control member is further configured to partially decouple the stress of the flexible display panel and the flexible outer member when the flexible display device is bent.

3. The flexible display device of claim 1, wherein the flexible outer member is disposed on a display surface of the flexible display panel, the flexible outer member comprising at least one of a touch panel, an optical member, and a window member, and
   the flexible display panel is configured to display an image through the display surface.

4. The flexible display device of claim 1, wherein the flexible display panel comprises a plurality of pixels, and
   each of the plurality of pixels comprises an organic light emitting diode and a thin film transistor configured to control the organic light emitting diode.

5. The flexible display device of claim 4, wherein the touch panel comprises a first conductive layer and a second conductive layer spaced apart from the first conductive layer.

6. The flexible display device of claim 1, wherein the flexible outer member comprises a protecting member disposed on a non-display surface opposite to a display surface of the flexible display panel, and the flexible display panel displays an image through the display surface.

7. The flexible display device of claim 1, wherein the stress control member comprises a pressure sensitive adhesive sheet.

8. The flexible display device of claim 1, wherein the stress control member is configured to have a maximum shear strain of about 150% or more at a bent portion when the flexible display device is bent.

9. The flexible display device of claim 8, wherein the flexible display device is configured, such that a maximum shear strain in a bent portion of each of the flexible display panel and the flexible outer member is about 10% or less when the flexible display device is bent.

10. The flexible display device of claim 1, wherein the flexible display device is further configured to be bent with a radius of curvature in a range of about 3 mm to about 20 mm.

11. A flexible display device of claim 1,
whereinthe stress control member is configured to physically couple the flexible display panel and the flexible outer member to each other,
wherein the flexible display device is configured to partially decouple a stress of the flexible display panel from a stress of the flexible outer member by the stress control member when the flexible display device is bent, such that a strain at one surface of the flexible display panel adjacent to the stress control member occurs by either one of a compressive stress or a tensile stress, and a strain at one surface of the flexible outer member adjacent to the stress control member occurs by the other one of the compressive stress or the tensile stress.

12. The flexible display device of claim 11, wherein the flexible display device is further configured such that, when the flexible display device is bent, a strain at the one surface of the flexible display panel occurs by either one of a compressive stress or a tensile stress, and a strain at the other surface of the flexible display panel occurs by the other one of the compressive stress or the tensile stress.

13. The flexible display device of claim 12, wherein the flexible display device member is further configured such that, when the flexible display device is bent, a strain at the one surface of the flexible outer member occurs by either one of a compressive stress or a tensile stress, and a strain at the other surface of the flexible outer member occurs by the other one of the compressive stress or the tensile stress.

14. The flexible display device of claim 11, wherein the stress control member is configured to have a maximum shear strain of about 150% or more at a bent portion when the flexible display device is bent.

15. The flexible display device of claim 14, wherein the flexible display device is further configured, such that a maximum shear strain in a bent portion of each of the flexible display panel and the flexible outer member is about 10% or less when the flexible display device is bent.

# FIG. 1A

# FIG. 1B

# FIG. 2

# FIG. 3

# FIG. 4

# FIG. 5

# FIG. 6A

# FIG. 6B

# FIG. 7A

# FIG. 7B

# FIG. 7C

# FIG. 8A

RA
SAN20
SA40 SA30
OS IS
DD-S2
OSM-S2
SNP20
AM-S2
SNP10
DP-S2
I
SA20 SA10
SAN10
NDS
DS
I'
T20
T30
T10
AX

# FIG. 8B

SA40
RA
SAN20
SNP20
SA30
GR2-2
SA20
SAN10
SNP10
GR2-1
SA10

Tensile Strain (%)　　　　0　　　　Compressive Strain (%)

# FIG. 9A

# FIG. 9B

# FIG. 9C

# FIG. 9D

# FIG. 9E

# FIG. 10A

# FIG. 10B

# FIG. 10C

# FIG. 11A

# FIG. 11B

# FIG. 12

DD10

AM3 — 

AM2 — 
DS — 
NDS — 
AM1 — 

— WM
— LF
— TSP
— DP
— PF

# FIG. 13

GR-4

WM

AM3

LF/TSP

AM2

DP
AM1
PF

— NP

— NP

GR-3

GR-2

— NP
— NP

Tensile Strain (%)  Compressive Strain (%)

GR-1

# FIG. 14A

# FIG. 14B

# FIG. 14C

# FIG. 15A

# FIG. 15B

DD30

AM — WM

AM — TSP

AM — DP

— PF

# FIG. 15C

DD40

AM — WM

AM — LF

AM — DP

— PF

# FIG. 15D

DD50

AM — 
AM — 
AM — 

— WM
— LF
— TSP
— DP

# FIG. 15E

DD60

AM — 
AM — 
AM — 
AM — 

— WM
— LF
— DP
— TSP
— PF

Europäisches
Patentamt

European
Patent Office

Office européen
des brevets

## EUROPEAN SEARCH REPORT

Application Number

EP 15 15 0261

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 2 833 426 A2 (SAMSUNG DISPLAY CO LTD [KR]) 4 February 2015 (2015-02-04) * paragraphs [0035], [0036]; figures 1,2A,2B * | 1-6, 10-13 | INV. H01L27/32 G06F3/041 G09F9/30 |
| X | US 2010/295812 A1 (BURNS SEAMUS [GB] ET AL) 25 November 2010 (2010-11-25) * paragraphs [0013], [0015], [0021], [0037], [0042], [0050]; figures 2,3 * | 1-5,7-9, 11-15 | |
| X | WO 2013/161868 A1 (SHARP KK) 31 October 2013 (2013-10-31) * paragraphs [0012] - [0014], [0049], [0059], [0070], [0074], [0088]; figures 2,7 * | 1-3,5,6, 11-13 | |
| X | EP 2 259 321 A1 (SAMSUNG MOBILE DISPLAY CO LTD [KR]) 8 December 2010 (2010-12-08) * paragraphs [0065], [0073], [0087] - [0098]; figures 1,2,5,6 * | 1,4,10 | |
| A | US 2011/090162 A1 (SHIH PO-SHENG [TW]) 21 April 2011 (2011-04-21) * figure 4A * | 1-15 | TECHNICAL FIELDS SEARCHED (IPC) H01L G06F G09F G09G H04M |

The present search report has been drawn up for all claims

| Place of search | Date of completion of the search | Examiner |
|---|---|---|
| The Hague | 13 May 2015 | Fratiloiu, Silvia |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

EP 2 894 672 A1

## ANNEX TO THE EUROPEAN SEARCH REPORT
## ON EUROPEAN PATENT APPLICATION NO.

EP 15 15 0261

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2015

| Patent document cited in search report | | Publication date | Patent family member(s) | | Publication date |
|---|---|---|---|---|---|
| EP 2833426 | A2 | 04-02-2015 | CN | 104347007 A | 11-02-2015 |
| | | | EP | 2833426 A2 | 04-02-2015 |
| | | | JP | 2015031953 A | 16-02-2015 |
| | | | KR | 20150015224 A | 10-02-2015 |
| | | | US | 2015036269 A1 | 05-02-2015 |
| US 2010295812 | A1 | 25-11-2010 | CN | 101223494 A | 16-07-2008 |
| | | | JP | 5514439 B2 | 04-06-2014 |
| | | | JP | 2009503571 A | 29-01-2009 |
| | | | JP | 2013101626 A | 23-05-2013 |
| | | | KR | 20140008440 A | 21-01-2014 |
| | | | US | 2010295812 A1 | 25-11-2010 |
| | | | US | 2013265280 A1 | 10-10-2013 |
| WO 2013161868 | A1 | 31-10-2013 | US | 2015103268 A1 | 16-04-2015 |
| | | | WO | 2013161868 A1 | 31-10-2013 |
| EP 2259321 | A1 | 08-12-2010 | AT | 543222 T | 15-02-2012 |
| | | | CN | 101908555 A | 08-12-2010 |
| | | | EP | 2259321 A1 | 08-12-2010 |
| | | | JP | 2010282966 A | 16-12-2010 |
| | | | JP | 2013254747 A | 19-12-2013 |
| | | | KR | 20100130898 A | 14-12-2010 |
| | | | TW | 201044899 A | 16-12-2010 |
| | | | US | 2010308335 A1 | 09-12-2010 |
| US 2011090162 | A1 | 21-04-2011 | CN | 102043299 A | 04-05-2011 |
| | | | US | 2011090162 A1 | 21-04-2011 |

EPO FORM P0459

For more details about this annex : see Official Journal of the European Patent Office, No. 12/82